# EUROPÄISCHE PATENTSCHRIFT

(11) **EP 1 794 803 B1**
(45) Veröffentlichungstag und Bekanntmachung des Hinweises auf die Patenterteilung: **30.12.2009**
(21) Anmeldenummer: 05796900.8
(22) Anmeldetag: 28.09.2005
(51) Int. Cl.: H01L 29/78, H01L 29/423, H01L 21/336

(54) **Verfahren zur Herstellung eines lateralen DMOS-Transistors**
Method of manufacturing a lateral DMOS-Transistor
Procédé de fabrication d'un transistor DMOS latéral

(30) Priorität: 01.10.2004 DE 102004049246
(43) Veröffentlichungstag der Anmeldung: 13.06.2007
(73) Patentinhaber: Atmel Automotive GmbH, 74072 Heilbronn (DE)
(72) Erfinder: DIETZ, Franz, 74257 Untereisesheim (DE); DUDEK, Volker, 76275 Ettlingen (DE); HOFFMANN, Thomas, 70469 Stuttgart (DE); GRAF, Michael, 71397 Leutenbach (DE); SCHWANTES, Stefan, 22549 Hamburg (DE)
(74) Vertreter: Müller, Wolf-Christian
(86) Internationale Anmeldenummer: PCT/EP2005/010455
(87) Internationale Veröffentlichungsnummer: WO 2006/037526

(56) Entgegenhaltungen:
- US-A- 5 821 144
- US-A- 5 918 133
- US-A1- 2003 153 154
- US-B1- 6 468 870
- TSAI C-Y ET AL: "SPLIT GATE MOSFETS IN BICMOS POWER TECHNOLOGY FOR LOGIC LEVEL GATE VOLTAGE APPLICATION" 11TH. INTERNATIONAL SYMPOSIUM ON POWER SEMICONDUCTOR DEVICES AND IC S.ISPSD 99. PROCEEDINGS. TORONTO, MAY 26 - 28, 1999, INTERNATIONAL SYMPOSIUM ON POWER SEMICONDUCTOR DEVICES & IC'S, NEW YORK, NY : IEEE, US, 26. Mai 1999 (1999-05-26), Seiten 85-88, XP000903551 ISBN: 0-7803-5291-2
- VANDOOREN A. ET AL: "Back-gate and series resistance effects in LDMOSFETs on SOI" IEEE TRANSACTIONS ON ELECTRON DEVICES, vol. 48, no. 9, September 2001 (2001-09), pages 2410-2416, XP011017842

## Beschreibung

Die Erfindung betrifft ein Verfahren zur Herstellung eines lateralen DMOS-Transistors mit den Schritten: Erzeugen einer MOS-Diode, die Halbleitermaterial eines ersten Leitfähigkeitstyps aufweist, eines Source-Bereiches eines zweiten Leitfähigkeitstyps und eines Drain-Bereiches des zweiten Leitfähigkeitstyps, der von der MOS-Diode durch eine Driftregion aus Halbleitermaterial des zweiten Leitfähigkeitstyps getrennt ist, Bedecken der MOS-Diode und wenigstens eines Teils der Driftregion durch eine dielektrische Gate-Schicht, die einen ersten Bereich einer ersten Dicke und einen zweiten Bereich einer zweiten Dicke aufweist, wobei der erste Bereich Halbleitermaterial der MOS-Diode abdeckt und der zweite Bereich auf der Driftregion liegt.

Ein Verfahren ist aus der US 6 191 453 bekannt.

Aus "Back-Gate and Series Resistance Effects in LDMOSFETs on SOI", Vandooren et. al., IEEE TRANSACTIONS ON ELECTRON DEVICES, VOL. 48, NO. 9, SEPTEMBER 2001 ist ein LDMOSFET auf einem SOI-Substrat bekannt. Aus der US 2003/0153154 A1 ist ein Halbleiterbauelement mit isolierenden Schichten mit drei unterschiedlichen Dicken bekannt. Oberhalb der isolierenden Schichten ist eine Gate-Elektrode angeordnet.

Aus der US 5,918,133 ist ein Halbleiterbauelement mit zwei Dicken des Gate-Dielektrikums innerhalb des Kanalgebiets bekannt. Aus der US 5,821,144 ist eine lateraler DMOS-Transistor für RF-Anwendungen bekannt. Dieser weist ein Gate-Oxid und ein Bump-Oxid auf, wobei sich über beide ein Gate erstreckt. Unterhalb des Gate-Oxids wird ein Kanalgebiet und unterhalb des Bump-Oxids wird eine N-Drift Region ausgebildet.

Im Rahmen der vorliegenden Erfindung wird unter einer MOS-Diode jede Schichtfolge aus leitfähiger Steuerelektrode, dielektrischer Isolierschicht und Schicht aus Halbleitermaterial verstanden, in der durch Einstellung eines geeigneten Steuerelektrodenpotenzials eine leitfähige Inversionsschicht erzeugt werden kann. Der Vollständigkeit halber sei erwähnt, dass unter einer Inversionsschicht eine Schicht verstanden wird, in der die Konzentration der Minoritätsladungsträger der Halbleiterschicht durch Einflüsse des Steuerelektrodenpotenzials größer wird als die Konzentration der Majoritätsladungsträger. Die Metall-Schicht der MOS-Diode kann alternativ zum namensgebenden Metall auch aus hochleitfähige Halbleitermaterial bestehen. Die Oxid-Schicht der MOS-Diode kann alternativ zum namensgebenden Oxid auch aus anderem dielektrischen Material bestehen, was auch für die weiter unten offenbarten Ausführungsbeispiele und Ausgestaltungen gilt.

Ein MOS-Transistor entsteht aus einer solchen MOS-Diode bekanntlich dadurch, dass die Halbleiterschicht der MOS-Diode an einen Drain-Bereich und einen Source-Bereich aus Halbleitermaterial angrenzt, die einen zum Leitfähigkeitstyp der MOS-Dioden-Halbleiterschicht entgegengesetzten Leitfähigkeitstyp aufweisen und daher mit dem Halbleitermaterial der MOS-Diode zwei entgegengesetzt ausgerichtete PN-Übergänge bilden. Ohne Effekte, die durch Steuerelektrodenpotenziale erzeugt werden, sperrt eine Spannung, die von außen zwischen dem Source-Bereich und dem Drain-Bereich erzeugt wird, einen der beiden PN-Übergänge, so dass kein Drainstrom zwischen Drain-Bereich und Source-Bereich fließt. Beim zusätzlichen Anlegen eines ausreichend hohen Steuerpotenzials entsteht dagegen durch die Inversion der Ladungsträgerkonzentrationen in einer an das Dielektrikum angrenzenden Inversionsschicht im Halbleitermaterial ein nicht durch PN-Übergänge begrenzter leitfähiger Kanalbereich und damit ein Stromfluss zwischen Source-Bereich und Drain-Bereich.

Frühere Leistungs-MOS-Transistoren zeichneten sich durch einen vertikalen Aufbau aus, bei dem Source-Bereiche und Drain-Bereiche in einer Richtung senkrecht zur Steuerelektrode durch eine Halbleiterschicht getrennt waren. Die beschriebene MOS-Struktur mit zwei PN-Übergängen wurde durch eine namensgebende Doppeldiffusion zur DMOS-Struktur, wobei eine erste Eindiffusion eines P-Wannenbereiches in ein N-Material erfolgte und eine nachfolgende Eindiffusion eines N-Bereiches in den P-Wannenbereich erfolgte. Dabei diente das Gate-Oxid als Maske für Dotierstoffimplantationen. Der laterale Abstand zwischen beiden Diffusionsgrenzen bildete das parallel zum Gate-Oxid liegende Oberflächen-KanalGebiet zum gesteuerten Erzeugen der Inversion. Das übrige, zwischen dem P-Wannenbereich und dem Drain-Bereich liegende Material der genannten Halbleiterschicht bildete eine Driftregion.

Heute versteht man unter einem DMOS-Transistor weniger einen durch einen Doppeldiffusionsprozess hergestellten MOS-Transistor als vielmehr jeden MOS-Transistor, bei dem der Kanalbereich durch eine Driftregion von dem Drain-Bereich getrennt ist. Die Driftregion sorgt für einen reduzierten Potenzialgradienten zwischen Source-Bereich und Drain-Bereich und verbessert damit die Spannungsfestigkeit des MOS-Transistors. DMOS-Transistoren finden als Hochspannungsbauelemente Anwendung, in denen zwischen dem Drain-Bereich und dem Source-Bereich Spannungen, so genannte Drain-Spannungen, von mehr als 100 Volt angelegt werden können.

Zur Verbesserung der elektrischen Eigenschaften von DMOS-Transistoren werden zunehmend dünne Gate-Oxide von CMOS-Transistoren (C = Complementary) auch für DMOS-Treibertransistoren verwendet. Mit abnehmender Gate-Oxiddicke sinkt jedoch die Spannungsfestigkeit, so dass die DMOS-Transistoren empfindlicher auf Spannungsspitzen reagieren.

Zur Verbesserung der elektrischen Eigenschaften von MOS-Transistoren offenbart die oben genannte US 6 191 453 eine kreisförmige Struktur, bei der die Source-Elektrode an einem äußeren Umfang und die Drain-Elektrode an einem inneren Umfang angeordnet ist. Eine dielektrische Gate-Schicht weist im Kanalbereich der Struktur eine geringere Dicke auf als im Bereich einer Driftregion. Dabei erstreckt sich der Teil der Gate-Schicht, der die geringere Dicke aufweist, über den Kanalbereich hinaus auf die Driftregion, so dass ein dem Kanalbereich benachbarter Teil der Driftregion ebenfalls mit der Gate-Schicht der geringeren Dicke bedeckt ist. Die US 6 191 453 offenbart keine Details zum Herstellungsverfahren. Allerdings weist der sich in die Tiefe des Halbleitersubstrates erstreckende und sich seitlich gestuft verjüngende Querschnitt der Gate-Schicht auf eine Herstellung durch mehrfache Anwendung eines LOCOS-Prozesses hin, also auf eine Gate-Oxidbildung durch eine locale Oxidation von Silizium.

Aufgrund der verwendeten LOCOS Technik kommt es zu einem unscharfen Übergang zwischen der ersten Oxiddicke und der zweiten Oxiddicke sowie zu einem ausgeprägten Verbrauch an Silizium im Substrat. Der Siliziumverbrauch führt zu einer Kante im Substrat, die mit einer unerwünschten Erhöhung des Einschaltwiderstandes einhergeht.

Ein vorrangiges Ziel in der Entwicklung auf dem Gebiet der DMOS Transistoren besteht darin, einen niedrigen spezifischen Einschaltwiderstand bei gleichzeitig hoher Spannungsfestigkeit zu erzielen. Damit soll bei integrierten Schaltungen, bei denen die DMOS Transistoren einen wesentlichen Anteil an der Gesamt-Chip-Fläche beanspruchen, der Flächenverbrauch der integrierten Schaltungen reduziert werden.

Vor diesem Hintergrund besteht die Aufgabe der Erfindung in der Angabe eines Verfahrens zur Herstellung eines lateralen DMOS-Transistors mit weiter verbesserten elektrischen Parametern wie hoher Spannungsfestigkeit, kleinem Einschaltwiderstand und hohem Sättigungsstrom.

Diese Aufgabe wird bei einem Verfahren der eingangs genannten Art durch die Merkmale des Anspruchs 1 gelöst. Insbesondere wird demnach über einem der MOS-Diode zugewandten Randbereich der Driftregion eine Gate-Schicht mit der zweiten Dicke erzeugt. Durch einen Lithografieschritt wird eine Kante einer Maske zur Erzeugung der ersten Dicke und der zweiten Dicke der Gate-Schicht justiert über einem PN-Übergang positioniert, der die Wannenbereiche trennt.

Durch diese Merkmale wird einerseits im Bereich des Kanals des DMOS-Transistors ein dünnes Gate-Oxid verwendet, was zu einem erwünscht niedrigen Einschaltwiderstand führt. Das dickere Oxid im Bereich der Driftregion sorgt für eine hohe Spannungsfestigkeit des DMOS-Transistors. So hat sich bei Untersuchungen gezeigt, dass das elektrische Potenzial im zum Kanalbereich benachbarten Randbereich der Driftregion trotz der potenzialverringernden Wirkung der Driftregion noch so hoch sein kann, dass ein dünnes Gate-Oxid durchbrechen könnte. Durch die erfindungsgemäße Erzeugung und Anordnung einer Gate-Schicht mit der zweiten, größeren Dicke gerade in dem der MOS-Diode zugewandten Randbereich der Driftregion erhöht sich die Spannungsfestigkeit dort entscheidend. Im Kanalbereich können dagegen auch bei der Erfindung weiter die Vorteile einer geringen Gate-Schichtdicke über dem Kanalbereich genutzt werden, da hier keine größeren Potenzialdifferenzen über der Gate-Schicht auftreten. Als weiterer wichtiger Vorteil ergibt sich innerhalb einer integrierten Schaltung eine verbesserte Kompatibilität zwischen CMOS-Modulen, für die vergleichsweise geringe Gate-Schichtdicken günstig sind, und DMOS-Modulen, die bereichsweise größere Gate-Schichtdicken benötigen.

Eine bevorzugte Ausgestaltung eines solchen DMOS-Transistors zeichnet sich durch einen stufenförmigen Übergang zwischen dem ersten Bereich der ersten Dicke und dem zweiten Bereich der zweiten Dicke aus.

Die MOS-Diode wird von der Driftzone durch den PN-Übergang getrennt, wobei der PN-Übergang auch den Kanalbereich mit geringerer Durchbruchgefahr von dem Randbereich der Driftregion trennt, in dem noch eine größere Durchbruchgefahr besteht. Durch die stufenförmige Ausgestaltung des Übergangs zwischen dem ersten Bereich der ersten Dicke und dem zweiten Bereich der zweiten Dicke wird ein bestmöglicher Kompromiss zwischen der Anforderungen an eine gute Isolationswirkung über der Driftregion und der Anforderung an einen geringen Einschaltwiderstand der MOS-Diode erzielt.

Ferner ist bevorzugt, dass eine mit einem Dielektrikum gefüllte Grabenstruktur in der Driftregion zwischen dem Drain-Bereich und der MOS-Diode angeordnet ist.

Durch die Grabenstruktur wird eine Form der Driftregion mit einer teilweise vertikalen Ausbildung der Driftregion entlang der Seitenwände des Grabens erzielt, was die Länge der Driftregion und damit die Spannungsfestigkeit bei vorgegebener lateraler Ausdehnung verbessert. Allerdings können bei einer anliegenden Sperrspannung Inhomogenitäten in dem Potenzialverlauf an den Kanten der Grabenstruktur auftreten, die sich ungünstig auf die Sperrspannung des Transistors auswirken. Es ist ein besonderer Vorteil der Erfindung, dass sie die Spannungsfestigkeit auch in dem an die MOS-Diode angrenzenden Randbereich der Driftregion verbessert, da sich dort solche Inhomogenitäten bilden können.

Bevorzugt ist auch, dass der Source-Bereich in einen Wannenbereich aus Halbleitermaterial des ersten Leitfähigkeitstyps eingebettet ist, der auch das Halbleitermaterial für die MOS-Diode bildet. Ferner ist bevorzugt, dass der Drain-Bereich von einem Wannenbereich eines zweiten Leitfähigkeitstyps umgeben ist, der auch das Material der Driftregion bildet.

Diese Ausgestaltung lässt sich fertigungstechnisch im Rahmen eines Standardprozesses realisieren.

Bevorzugt ist auch, dass die Dicke der dielektrischen Gate-Schicht im Bereich der MOS-Diode 8 bis 12 nm und im Bereich der Driftregion 28 bis 32 nm beträgt.

Diese Dimensionen haben sich bei konkreten Anwendungen als vorteilhaft herausgestellt. Es versteht sich aber dass die Erfindung nicht auf diese Dimensionierung beschränkt ist.

Im Rahmen von Ausgestaltungen des Verfahrens ist bevorzugt, dass ein Halbleitersubstrat mit einer ersten dielektrischen Schicht bedeckt wird, dass die dielektrische Schicht über einem späteren Kanalbereich wenigstens teilweise entfernt wird, und dass die entstandene Struktur mit einer zweiten dielektrischen Schicht bedeckt wird, so dass sich ein erster Bereich einer ersten Dicke und ein zweiter Bereich einer zweiten Dicke ergibt, wobei die erste Dicke durch die Dicke der zweiten dielektrischen Schicht bestimmt wird und die zweite Dicke durch die Summe der Dicken der ersten dielektrischen Schicht und der zweiten dielektrischen Schicht bestimmt wird. Dabei kann die Dicke der zweiten dielektrischen Schicht von ihrer Unterlage abhängig sein. In der Regel wächst die zweite dielektrische Schicht auf freiliegendem Halbleitermaterial schneller als auf einer bereits vorhandenen Oxydschicht. Durch diese Ausgestaltung ergibt sich mit einer Folge von Standardschritten ein Herstellungsverfahren, bei dem sich beliebige Dicken des ersten Bereiches und des zweiten Bereiches einstellen lassen.

Bevorzugt ist auch, dass die Oberfläche eines Halbleitersubstrates, vor einem Aufwachsen einer dielektrischen Schicht, über einem späteren Kanalbereich anders präpariert wird als über einer Driftregion, so dass sich über dem späteren Kanalbereich eine geringere Aufwachsgeschwindigkeit der dielektrischen Schicht ergibt als über der Driftregion.

Diese Ausgestaltung hat den Vorteil, dass sich erfindungsgemäße Strukturen mit einer im Vergleich zur vorstehenden Ausgestaltung geringeren Zahl von Fertigungsschritten einstellen lassen.

Weitere Vorteile ergeben sich aus der Beschreibung und den beigefügten Figuren.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

### Zeichnungen

Ausführungsbeispiele der Erfindung sind in den Zeichnungen dargestellt und werden in der nachfolgenden Beschreibung näher erläutert. Es zeigen, jeweils in stark schematisierter Form:
- Fig. 1: ein Ausführurigsbeispiel eines erfindungsgemäßen lateralen DMOS-Transistors;
- Fig. 2: ein Vorprodukt des DMOS-Transistors aus Fig. 1 in einem ersten Zwischenstadium eines ersten Ausführungsbeispiels eines erfindungsgemäßen Herstellungsverfahrens;
- Fig. 3: das Vorprodukt aus Fig. 2 nach weiteren Verfahrensschritten;
- Fig. 4: das Vorprodukt aus Fig. 3 nach der Herstellung der dielektrischen Gate-Schicht mit einem ersten Bereich einer ersten Dicke und einem zweiten Bereich einer zweiten Dicke;
- Fig. 5: ein Vorprodukt des DMOS-Transistors aus Fig. 1 in einem ersten Zwischenstadium eines das Verständnis der Erfindung erleichternden Beispiels eines Herstellungsverfahrens;
- Fig. 6: ein Vorprodukt des DNIOS-Transistors aus Fig. 1 in einem ersten Zwischenstadium einer zweiten Variante eines zweiten Ausführungsbeispiels eines erfindungsgemäßen Herstellungsverfahrens; und
- Fig. 7: das Vorprodukt aus Fig. 5 oder Fig. 6 nach der Herstellung der dielektrischen Gate-Schicht mit einem ersten Bereich einer ersten Dicke und einem zweiten Bereich einer zweiten Dicke.

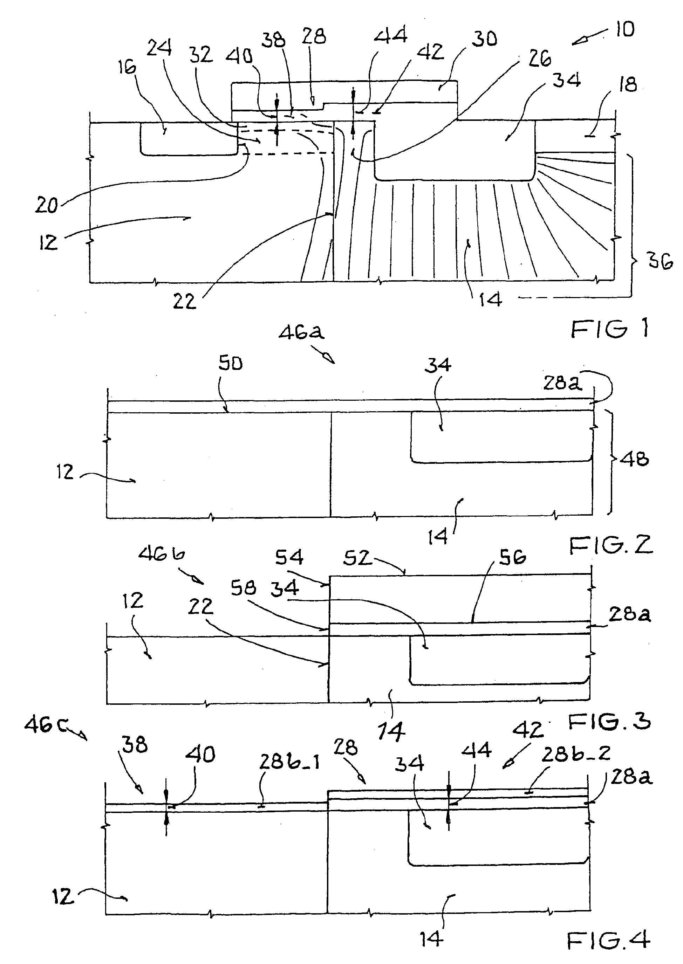

Figur 1 zeigt einen lateralen DMOS-Transistor 10, der einen ersten Wannenbereich 12 aus Halbleitermaterial eines ersten Leitfähigkeitstyps und einen zweiten Wannenbereich 14 aus Halbleitermaterial eines zweiten Leitfähigkeitstyps aufweist. Beide Leitfähigkeitstypen sind unterschiedlich, so dass bei einer P-Leitfähigkeit des ersten Wannenbereichs 12 der zweite Wannenbereich 14 eine N-Leitfähigkeit besitzt und umgekehrt. Ein Source-Bereich 16 vom zweiten Leitfähigkeitstyp ist im ersten Wannenbereich 12 angeordnet und der zweite Wannenbereich 14 weist einen Drain-Bereich 18 auf, der ebenfalls den zweiten Leitfähigkeitstyp besitzt. Der Drain-Bereich 18 weist damit denselben Leitfähigkeitstyp auf wie der angrenzende zweite Wannenbereich 14. Er unterscheidet sich von dem zweiten Wannenbereich 14 jedoch durch eine höhere Dotierstoffkonzentration und damit durch eine stärker ausgeprägte Leitfähigkeit.

Aufgrund der verschiedenen Leitfähigkeitstypen bildet sich zwischen dem Source-Bereich 16 und dem ersten Wannenbereich 12 ein PN-Übergang 20 aus. Analog bildet sich zwischen dem ersten Wannenbereich 12 und dem zweiten Wannenbereich 14 ein PN-Übergang 22 aus. Die beiden PN-Übergänge 20, 22 begrenzen einen zwischen ihnen liegenden Halbleiterbereich 24, der als Teilbereich des Wannenbereichs 12 den ersten Leitfähigkeitstyp besitzt. Der Halbleiterbereich 24 des ersten Leitfähigkeitstyps und ein angrenzender Teilbereich 26 des Wannenbereichs 14 des zweiten Leitfähigkeitstyps werden von einer dielektrischen Gate-Schicht 28 bedeckt, die bevorzugt aus Oxid oder Nitrid des Halbleitermaterials besteht. Auf der dielektrischen Gate-Schicht 28 erstreckt sich eine hochleitfähige, meist metallische Gate-Elektrode 30.

Der Halbleiterbereich 24, die darüber liegende Gate-Schicht 28 und die sich darauf erstreckende Gate-Elektrode 30 bilden die MOS-Diode (24, 28, 30), in der sich in Abhängigkeit vom elektrischen Potenzial der Gate-Elektrode 30 ein hoch leitfähiger Kanalbereich 32 vom zweiten Leitfähigkeitstyp im Halbleiterbereich 24 des ersten Leitfähigkeitstyps in einer an die dielektrische Gate-Schicht 28 angrenzenden Grenzschicht erzeugen lässt. Bei ausreichend positivem Potenzial der Gate-Elektrode 30 entsteht z. B. ein N-leitfähiger Kanalbereich 32 in einem P-leitfähigen Halbleiterbereich 24. Damit verschwinden die PN-Übergänge 20, 22 an den Grenzen des Kanalbereichs 32, womit eine durchgehende N-Leitfähigkeit zwischen Drain-Bereich 18 und Source-Bereich 16 entsteht. Bei einem Potenzialunterschied zwischen Source-Bereich 16 und Drain-Bereich 18 fließt dann ein Strom, dessen Stärke sich durch das elektrische Potenzial an der Gate-Elektrode 30 steuern lässt. Bei ausreichender Verringerung des positiven Potenzials an der Gate-Elektrode 30 verschwindet die Inversion der Leitfähigkeit in der Grenzschicht zur dielektrischen Gate-Schicht 28 und damit die Leitfähigkeit des Kanalbereichs 32. Bei einem Potenzialunterschied zwischen Source-Bereich 16 und Drain-Bereich 18 sperrt dann einer der beiden PN-Übergänge 20 oder 22, so dass kein Stromfluss zwischen Source-Bereich 16 und Drain-Bereich 18 auftritt.

Im Gegensatz zum Halbleiterbereich 24 tritt im Halbleiterbereich 26 aufgrund der andersartigen Leitfähigkeit keine Inversion an der Grenze zur dielektrischen Gate-Schicht 28 auf. Der Stromfluss über den Halbleiterbereich 26 und den übrigen zwischen dem ersten Wannenbereich 12 und dem Drain-Bereich 18 liegenden Wannenbereich 14 hängt daher im Wesentlichen von dem Potenzialunterschied zwischen Source-Bereich 16 und Drain-Bereich 18 ab. Da ein Teil der Spannung zwischen Source-Bereich 16 und Drain-Bereich 18 über dem auch als Driftregion bezeichneten zweiten Wannenbereich 14 abfällt, erhöht sich bei Vorhandensein einer solchen Driftregion die Spannungsfestigkeit zwischen Source-Bereich 16 und Drain-Bereich 18.

Eine dielektrische Grabenstruktur 34, zum Beispiel eine mittels der Shallow-Trench-Isolation-Technik (STI) hergestellte oxidgefüllte Grabenstruktur 34 reduziert das vertikale elektrische Feld und vermeidet damit einen frühzeitigen Durchbruch. Der außerhalb der MOS-Diode über dem Wannenbereich 14 und damit über der Driftregion liegende Teil der Gate-Elektrode 30, der eigentlich keine Gate-Funktion besitzt, wird auch als Feldplatte bezeichnet. Ohne die leitfähige Feldplatte käme es zu einem vorzeitigen Durchbruch aufgrund von Feldstärkespitzen an der driftseitigen Kante einer Gate-Elektrode. Die Grabenstruktur 34 verringert insbesondere das von einer Kante der Feldplatte ausgehende Feld im Halbleitermaterial der Wanne 14. Dadurch wird die Spannungsfestigkeit zwischen Drain-Bereich 18 und Source-Bereich 16 weiter erhöht. Die Ziffer 36 bezeichnet einen idealisierten Verlauf von Äquipotenziallinien in der Driftregion für den Fall eines sowohl gegenüber dem Source-Bereich 16 als auch gegenüber der Gate-Elektrode 28 positiven Drain-Bereichs 18, wobei Source- und Gate-Potenzial untereinander gleich sind. Unter solchen Randbedingungen ist das Potenzial in dem Teilbereich 26 des zweiten Wannenbereichs 14, der noch unter der dielektrischen Gate-Schicht 28 liegt, noch nicht vollständig abgebaut. Daher existiert ein Potenzialunterschied zwischen dem Teilbereich 26 und der Gate-Elektrode 30. Für hoch sperrende Transistoren 10 können hier leicht noch etwa 5-10 Volt vorliegen, so dass ein dünnes Gate-Oxid (Dicke < 10 nm) durchbrechen könnte. Im Kanalbereich 32 besteht diese Gefahr nicht mehr.

Man könnte nun einerseits die Dicke der dielektrischen Gate-Schicht 28 insgesamt so weit vergrößern, dass ihre Durchbruchfestigkeit ausreicht. Andererseits soll die Dicke der dielektrischen Gate-Schicht 28 über dem Kanalbereich 32 möglichst gering sein, um z. B. einen möglichst niedrigen Einschaltwiderstand zu erzielen.

Bei dem lateralen DMOS-Transistor 10 der Figur 1 wird dieser Zielkonflikt dadurch gelöst, dass die dielektrische Gate-Schicht 28 einen ersten Bereich 38 einer ersten Dicke 40 und einen zweiten Bereich 42 einer zweiten Dicke 44 aufweist, wobei der erste Bereich 38 Halbleitermaterial der MOS-Diode (24, 28, 30) abdeckt, also über dem Kanalbereich 32 liegt, und der zweite Bereich 42 auf dem Teilbereich 26 des zweiten Wannenbereichs 14, also auf der Driftregion liegt. Dabei ist wesentlich, dass ein Übergang von der ersten Dicke 40 auf die zweite Dicke 44 so erfolgt, dass ein der MOS-Diode (24, 28, 30) und damit dem Kanalbereich 32 zugewandter Randbereich der Driftregion, also insbesondere ein Randbereich des Teilbereichs 26, bereits unter dem zweiten Bereich 42 der dielektrischen Gate-Schicht 28 liegt. Mit anderen Worten: Der Übergang von der ersten Dicke 40 auf die zweite Dicke 44 soll auf jeden Fall so erfolgen, dass der an den PN-Übergang 22 angrenzende Randbereich der Drift-Region, also der Randbereich des Teilbereichs 26 des zweiten Wannenbereichs 14, ganz unter dem zweiten Bereich 42 der Gate-Schicht 28 liegt. Beim Gegenstand der Figur 1 kann der Übergang daher etwas links vom PN-Übergang 22 oder genau über dem PN-Übergang 22, nicht jedoch rechts vom PN-Übergang 22 sein. Im Idealfall erfolgt der Übergang stufenförmig und liegt genau über dem PN-Übergang 22. Die erste Dicke 40 beträgt z. B. 8 - 12 nm und die zweite Dicke 44 beträgt z. B. 28 - 32 nm.

Im Folgenden werden unter Bezug auf die Figuren 2-4, 6 und 7 verschiedene Ausführungsbeispiele eines erfindungsgemäßen Verfahrens zur Herstellung des DMOS-Transistors aus der Figur 1 erläutert.

Figur 2 zeigt ein Vorprodukt 46a des DMOS-Transistors 10, bei dem ein Halbleiter-Substrat 48 bereits einen Wannenbereich 12 eines ersten Leitfähigkeitstyps, einen Wannenbereich 14 eines zweiten Leitfähigkeitstyps und eine dielektrische Grabenstruktur 34 in dem Wannenbereich 14 aufweist. Nach einem Planarisieren des Halbleiter-Substrats 48 wird auf einer durch den Planarisierungsschritt entstandenen Oberfläche 50 zunächst eine erste dielektrische Gate-Schicht 28a aufgebracht. Dies kann bspw. durch eine thermische Oxidation des Halbleitermaterials an der Oberfläche 50 geschehen.

Anschließend wird über dem Wannenbereich 14 eine Maske 52, bspw. aus Fotolack erzeugt, wie sie in der Figur 3 dargestellt ist. Fig. 3 zeigt ein Vorprodukt 46b, das durch Weiterverarbeitung des Vorprodukts 46a erzeugt wird. Die Weiterverarbeitung umfasst einen z. B. isotrop erfolgenden Ätzschritt, der außerhalb der Maske 52 über dem ersten Wannenbereich 12 liegende Teile der dielektrischen Schicht 28a entfernt. Durch einen Lithografieschritt wird eine Kante 54 der Maske 52 möglichst genau über einem PN-Übergang 22 positioniert, der die Wannenbereiche 12, 14 trennt. Im Anschluss daran wird die Maske 52 entfernt, so dass eine Oberfläche 56 des Restes der dielektrischen Gate-Schicht 28a frei liegt. Die resultierende Oberfläche des Vorproduktes 46b weist dann eine Stufe 58 auf, wobei rechts von der Stufe eine dielektrische Schicht 28a frei liegt und links von der Stufe 58 eine Oberfläche des ersten Wannenbereichs 12 frei liegt.

Über der frei liegenden Oberfläche des Wannenbereichs 12, der Stufe 58 und des Restes der dielektrischen Schicht 28 wird eine weitere dielektrische Schicht 28b_1 und 28b_2 erzeugt, wie sie in Fig. 4 als Bestandteil des Vorproduktes 46c dargestellt ist. Auch dies kann z. B. durch eine thermische Oxidation erfolgen, bei der auf der vorher frei liegenden Oberfläche des Wannenbereichs 12 eine Oxidschicht 28b_1 und auf der Oberfläche des Restes der dielektrischen Schicht 28a eine Oxidschicht 28b_2 aufwächst.. Dabei kann die Dicke der weiteren dielektrischen Schichten 28b_1und 28b_2 unterschiedlich sein, da Oxid auf freiliegendem Halbleitermaterial schneller aufwächst als auf einer bereits vorhandenen Oxidschicht.

Die Gesamtheit der dielektrischen Schichten 28a, 28b_1 und 28b_2 bildet die dielektrische Gate-Schicht 28 des DMOS-Transistors 10 aus der Figur 1. Figur 4 zeigt ein Vorprodukt 46c mit einer ersten dielektrischen Schicht 28a und einer zweiten dielektrischen Schicht 28b_1 sowie 28b_2. Der Teil 28b_1 der zweiten dielektrischen Schicht bildet den im Zusammenhang mit der Figur 1 erläuterten ersten Bereich 38 einer ersten Dicke 40. Der zweite Bereich 42 aus der Figur 1 mit der zweiten Dicke 44 wird dagegen durch die Summe der Dicken der ersten dielektrischen Schicht 28a und der zweiten dielektrischen Schicht 28b_2 definiert. Durch an sich bekannte Strukturierungs- und Dotierungsschritte wird anschließend aus dem in der Figur 4 dargestellten Vorprodukt 46c ein DMOS-Transistor 10 erzeugt, wie er im Zusammenhang mit der Figur 1 erläutert worden ist.

Alternativ zu einem solchen Herstellungsverfahren, bei dem die dielektrischen Schicht 28 der Figur 1 in zwei Abschnitten erzeugt wird, kann sie auch in einem einzigen Schritt erzeugt werden.

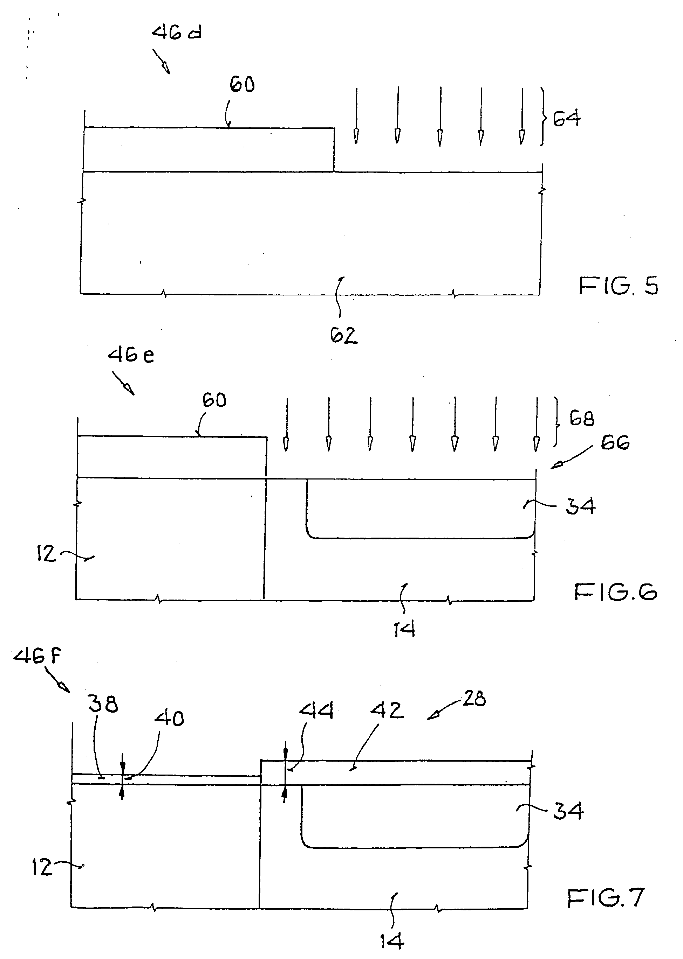

Varianten mit einem einzigen Schritt zur Erzeugung einer dielektrischen Stufenschicht werden im Folgenden unter Bezug auf die Figuren 5-7 erläutert. Beide Varianten haben gemeinsam, dass durch eine strukturierte Präparation einer Halbleiterobertläche bereichsweise unterschiedliche Wachstumsbedingungen für eine dielektrische Schicht geschaffen werden.

In einem das Verständnis der Erfindung erleichterndem Beispiel gemäß Figur 5 erfolgt eine bereichsweise Oberflächenpräparation zeitgleich und selbstjustiert mit einer Wannenimplantation. Die Fig. 5 zeigt die Gesamtheit eines Vorproduktes 46d eines DMOS-Transistors aus Fig. 1. Eine Maske 60 deckt einen Teil eines Halbleitersubstrats 62 ab, das z. B. zunächst einheitlich einen ersten Leitfähigkeitstyp aufweist. Anschließend erfolgt eine durch Pfeile 64 repräsentierte Dtierstoffimplantation zur Erzeugung einer Wanne aus Material eines zweiten Leitfähigkeitstyps. Gleichzeitig mit der Dotierung erfolgt eine chemische oder physikalische Oberflächenpräparation, die eine Wachstumsgeschwindigkeit einer dielektrischen Schicht in einem nachfolgenden Schritt beeinflusst.

Alternativ findet die chemische oder physikalische Oberflächenpräparation nach der Wannenimplantation statt. Dies wird für ein Vorprodukt 46e eines DMOS-Transistors in der Figur 6 durch Pfeile 68 repräsentiert. Im Unterschied zur Figur 5 weist ein Halbleitersubstrat 66 nach Figur 6 bereits zwei Wannenbereiche 12, 14 mit unterschiedlichen Leitfähigkeitstypen und eine dielektrische Grabenstruktur 34 auf. Einer der beiden Wannenbereiche 12, 14, beim Gegenstand der Figur 6 der Wannenbereich 12, in dem später der Kanalbereich erzeugt wird, wird von der Maske 60 abgedeckt, die den PN-Übergang zwischen beiden Wannenbereichen 12, 14 markiert. In diesem Fall erfolgt die durch Pfeile 68 repräsentierte Oberflächenpräparation so, dass über dem Wannenbereich 14 mit der dielektrischen Struktur 34 später ein schnelleres Wachstum von dielektrischem Material stattfindet als auf dem von der Maske 60 befreiten Wannenbereich 12.

Figur 7 zeigt die zu einem Vorprodukt 46f weiterverarbeiteten Halbleiter-Substrate aus der Figur 5 sowie aus der Figur 6 nach einem Entfernen der Maske 60 und einem Aufbringen der dielektrischen Schicht 28, was z. B. durch eine thermische Oxidation erfolgen kann. Aufgrund der im Zusammenhang mit den Figuren 5 und 6 erläuterten bereichsweise unterschiedlichen Oberflächenpräparation wächst das Oxid über dem Wannenbereich 14 schneller als über dem Wannenbereich 12, so dass sich eine dielektrische Schicht 28 mit einem ersten Bereich 38 einer ersten Dicke 40 und einem zweiten Bereich 42 mit einer zweiten Dicke 44 und einem stufenförmigen Übergang zwischen beiden Dicken einstellt, wobei der stufenförmige Übergang genau über dem PN-Übergang zwischen den Wannenbereichen 12 und 14 erfolgt.

## Patentansprüche

1. Verfahren zur Herstellung eines lateralen DMOS-Transistors (10) in dem
- eine MOS-Diode (24, 28, 30) in einem ersten Wannenbereich (12) eines ersten Leitfähigkeitstyps erzeugt wird, wobei die MOS-Diode (24, 28, 30) Halbleitermaterial (24) des ersten Leitfähigkeitstyps aufweist,
- ein Source-Bereich (16) eines zweiten Leitfähigkeitstyps in dem ersten Wannenbereich (12) erzeugt wird,
- ein Drain-Bereich (18) des zweiten Leitfähigkeitstyps in einem zweiten Wannenbereich (14) des zweiten Leitfähigkeitstyps erzeugt wird, der von der MOS-Diode (24, 28, 30) durch eine innerhalb des zweiten Wannenbereichs (14) ausgebildete Driftregion aus Halbleitermaterial des zweiten Leitfähigkeitstyps getrennt ist,
- das Halbleitermaterial (24) der MOS-Diode (24, 28, 30) und ein Teil der Driftregion durch eine dielektrische Gate-Schicht (28) bedeckt wird, die einen ersten Bereich (38) einer ersten Dicke (40) und einen zweiten Bereich (42) einer größeren zweiten Dicke (44) aufweist, wobei der erste Bereich (38) das Halbleitermaterial der MOS-Diode (24, 28, 30) abdeckt und der zweite Bereich (42) auf einem der MOS-Diode (24, 28, 30) zugewandten Randbereich (26) der Driftregion liegt, **dadurch gekennzeichnet, dass**
- durch einen Lithografieschritt eine Kante (54) einer Maske (52, 60) zur Erzeugung der ersten Dicke (40) und der zweiten Dicke (44) der Gate-Schicht (28) justiert über einem PN-Übergang (22) positioniert wird, der die Wannenbereiche (12, 14) trennt.

2. Verfahren nach Anspruch 1, **dadurch gekennzeichnet, dass** ein Halbleitersubstrat mit einer ersten dielektrischen Schicht (28a) bedeckt wird, dass die dielektrische Schicht (28a) über einem späteren Kanalbereich (32) mittels der Maske (52) wenigstens teilweise entfernt wird, und dass die entstandene Struktur mit einer zweiten dielektrischen Schicht (28b_1, 28b_2) bedeckt wird, so dass sich der erste Bereich (38) der ersten Dicke (40) und der zweite Bereich (42) der zweiten Dicke (44) ergibt, wobei die erste Dicke (40) durch die Dicke der zweiten dielektrischen Schicht (28b_1, 28b_2) bestimmt wird und die zweite Dicke (44) durch die Summe der Dicken der ersten dielektrischen Schicht (28a) und der zweiten dielektrischen Schicht (28b_1, 28b_2) bestimmt wird.

3. Verfahren nach Anspruch 1, bei dem die Oberfläche eines Halbleitersubstrates (62; 66), vor einem Aufwachsen einer dielektrischen Schicht als Gate-Schicht (28), über einem späteren Kanalbereich (32) anders präpariert wird als über der Driftregion, so dass sich über dem späteren Kanalbereich (32) eine geringere Aufwachsgeschwindigkeit der dielektrischen Gate-Schicht (28) ergibt als über der Driftregion.

## Claims

1. Method of producing a lateral DMOS transistor (10), in which:
- an MOS diode (24, 28, 30) is produced in a first trough region (12) of a first conductivity type, wherein the MOS diode (24, 28, 30) comprises semiconductor material (24) of the first conductivity type,
- a source region (16) of a second conductivity type is produced in the first trough region (12),
- a drain region (18) of the second conductivity type is produced in a second trough region (14) of the second conductivity type, which is separated from the MOS diode (24, 28, 30) by a drift region, which is formed within the second trough region (14), of semiconductor material of the second conductivity type,
- the semiconductor material (24) of the MOS diode (24, 28, 30) and a part of the drift region covered by a dielectric gate layer (28), which has a first region (38) of a first thickness (40) and a second region (42) of a greater second thickness (44), wherein the first region (38) covers the semiconductor material of the MOS diode (24, 28, 30) and the second region (42) lies on an edge region (26) of the drift region facing the MOS Ddiode (24, 28, 30),
**characterised in that**
- through a lithography step an edge (54) of a mask (52, 60) for producing the first thickness (40) and the second thickness (44) of the gate layer (28) is positioned in adjusted location above a PN transition (22) separating the trough regions (12, 14).

2. Method according to claim 1, **characterised in that** a semiconductor substrate is covered by a first dielectric layer (28a) at the dielectric layer (28a) is at least partly removed above a later channel region (32) by means of the mask (52) and that the created structure is covered by a second dielectric layer (28b_1, 28b_2), so that the first region (38) of the first thickness (40) and the second region (42) of the second thickness (44) result, wherein the first thickness (40) is determined by the thickness of the dielectric layer (28b_1, 28b_2) and the second thickness (44) is determined by the sum of the thicknesses of the first dielectric layer (28a) and the second dielectric layer (28b_1, 28b_2).

3. Method according to claim 1, in which the surface of the semiconductor substrate (62, 66) prior to epitaxial growth of a dielectric layer as gate layer (28) is prepared differently over a later channel region (32) than over the drift region so that a lower epitaxial growth rate of the dielectric gate layer (28) results over the later channel region (32) than over the drift region.

## Revendications

1. Procédé de fabrication d'un transistor DMOS latéral (10), dans lequel :
- on forme une diode MOS (24, 28, 30) dans une première zone en forme de cuvette (12) d'un premier type de conductivité, la diode MOS (24, 28, 30) présentant un matériau semi-conducteur (24) du premier type de conductivité,
- on forme une zone source (16) d'un deuxième type de conductivité dans la première zone en forme de cuvette (12),
- on forme une zone drain (18) du deuxième type de conductivité dans une deuxième zone en forme de cuvette (14) du deuxième type de conductivité, séparée de la diode MOS (24, 28, 30) par une zone de dérive en matériau semi-conducteur du deuxième type de conductivité, formée à l'intérieur de la deuxième zone en forme de cuvette (14),
- on recouvre le matériau semi-conducteur (24) de la diode MOS (24, 28, 30) et une partie de la zone de dérive d'une couche formant une grille diélectrique (28) présentant une première zone (38) d'une première épaisseur (40) et une deuxième zone (42) d'une deuxième épaisseur (44), la première zone (38) recouvrant le matériau semi-conducteur de la diode MOS (24, 28, 30) et la deuxième zone (42) reposant sur une zone périphérique (26) de la zone de dérive en regard de la diode MOS (24, 28, 30),
**caractérisé en ce que** par une étape de lithographie on positionne de manière ajustée une arête (54) d'un masque (52, 60) au-dessus d'une jonction PN (22) séparant les zones en forme de cuvette (12, 14) pour former la première épaisseur (40) et la deuxième épaisseur (44) de la couche formant une grille (28).

2. Procédé selon la revendication 1,
**caractérisé en ce qu'**un substrat semi-conducteur est recouvert d'une première couche diélectrique (28a) **en ce que** l'on enlève au moins partiellement la couche diélectrique (28a) au-dessus d'une zone ultérieure de canal (32) au moyen du masque (52), et **en ce que** l'on recouvre la structure ainsi formée d'une deuxième couche diélectrique (28b_1, 28b_2), de manière à former la première zone (38) de la première épaisseur (40) et la deuxième zone (42) de la deuxième épaisseur (44), la première épaisseur (40) étant déterminée par l'épaisseur de la deuxième couche diélectrique (28b_1, 28b_2) et la deuxième épaisseur (44) étant déterminée par la somme des épaisseurs de la première couche diélectrique (28a) et de la deuxième couche diélectrique (28b_1, 28b_2).

3. Procédé selon la revendication 1, dans lequel la surface d'un substrat semi-conducteur (62; 66), avant croissance d'une couche diélectrique comme couche formant une grille (28), est préparée différemment au-dessus d'une zone ultérieure de canal (32) qu'au-dessus de la zone de dérive, de sorte qu'au-dessus de la zone ultérieure de canal (32) on obtient une vitesse de croissance de la couche formant une grille diélectrique (28) inférieure à celle obtenue au-dessus de la zone de dérive.
